(19) Europäisches Patentamt / European Patent Office / Office européen des brevets

(11) **EP 1 946 241 B1**

(12) **EUROPEAN PATENT SPECIFICATION**

(45) Date of publication and mention of the grant of the patent:
**28.11.2012 Bulletin 2012/48**

(51) Int Cl.:
***G06G 7/20*** (2006.01)

(21) Application number: **06813730.6**

(22) Date of filing: **25.08.2006**

(86) International application number:
**PCT/US2006/033171**

(87) International publication number:
**WO 2007/046950 (26.04.2007 Gazette 2007/17)**

(54) **CURRENT SQUARING CELL**

STROMQUADRIERUNGSZELLE

CELLULE D'ÉLÉVATION AU CARRÉ DE COURANT

(84) Designated Contracting States:
**DE FR GB IT NL**

(30) Priority: **20.10.2005 US 253565**

(43) Date of publication of application:
**23.07.2008 Bulletin 2008/30**

(73) Proprietor: **Linear Technology Corporation
Milpitas, CA 95035-7417 (US)**

(72) Inventor: **ZOU, Min, Z.
San Jose, CA 95120 (US)**

(74) Representative: **Müller-Boré & Partner
Patentanwälte
Grafinger Straße 2
81671 München (DE)**

(56) References cited:
**GB-A- 2 325 341        GB-A- 2 335 061
US-A- 6 107 858        US-A1- 2005 107 055
US-B1- 6 204 719**

**Description**

**Technical Field**

The subject matter presented herein relates to a circuit architecture for squaring an input current.

**Background**

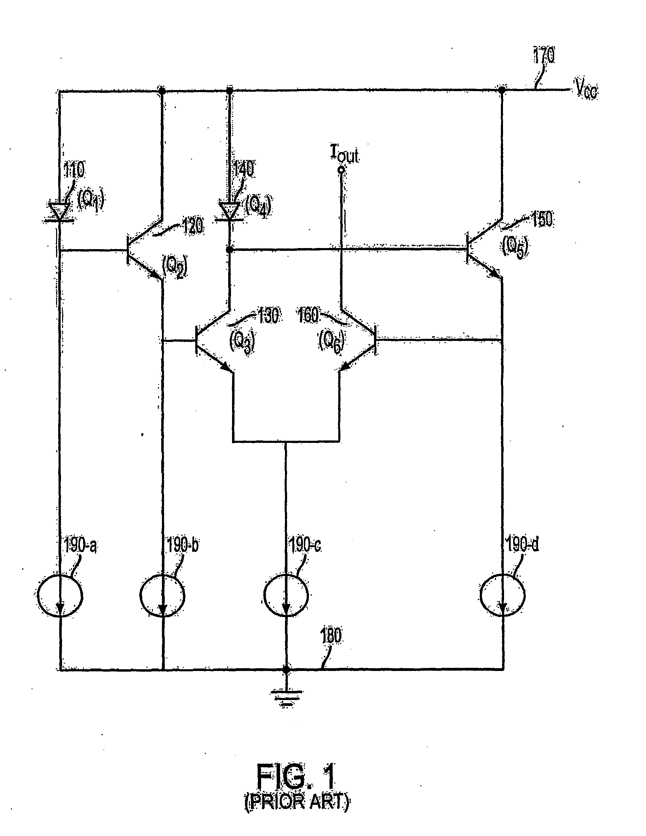

A circuit for current multiplication is illustrated in Fig. 1. Based on translinear loop equations, the following relationships hold:

$$V_{be1} + V_{be2} + V_{be3} = V_{be4} + V_{be5} + V_{be6}, \quad (1)$$

$$I_{c1} * I_{c2} * I_{c3} = I_{c4} * I_{c5} * I_{c6}, \text{ and} \quad (2)$$

$$I_{out} = I_{c6} = I_{c1} * I_{c2} / I_{c5} \quad (3)$$

where $V_{be1}$ represents the voltage measured between the anode terminal and cathode of a first diode 110 ($Q_1$); $V_{be2}$ represents the voltage between the base and emitter of a first transistor 120 ($Q_2$); $V_{be3}$ represents the voltage between the base and emitter of a second transistor 130 ($Q_3$); $V_{be4}$ represents the voltage between the anode and the cathode of a second diode 140 ($Q_4$); $V_{be5}$ represents the voltage between the base and emitter electrode of a third transistor 150 ($Q_5$); and $V_{be6}$ represents the voltage between the base and emitter of a fourth transistor 160 ($Q_6$). In addition, $I_{c1}$ represents the current measured at the cathode of the first diode 110 ($Q_1$); $I_{c2}$ represents the current at the collector electrode of the first transistor 120 ($Q_2$); $I_{c3}$ represents the current at the collector of the second transistor 130 ($Q_3$); $I_{c4}$ represents the current at the cathode of the second diode 140 ($Q_4$); $I_{c5}$ represents the current at the collector of the third transistor 150 ($Q_5$); and $I_{c6}$ represents the current at the collector of the fourth transistor 160 ($Q_6$).

Although the circuit presented in Fig. 1 produces an output current $I_{out}$ that is a multiple of its input current, its output current is not necessarily a squared input current. Having a circuit that produces a squared input current has a number of practical applications. For example, a logarithmic amplifier for measuring the power of an RF signal often requires that the amplifier exhibit conformity to the known true square law over a broad dynamic range and be relatively independent of temperature. The subject matter described herein presents circuitry having these characteristics.

**BRIEF DESCRIPTION OF THE DRAWINGS**

The inventions claimed and/or described herein are further described in terms of exemplary embodiments. These exemplary embodiments are described in detail with reference to the drawings. These embodiments are non-limiting exemplary embodiments, in which like reference numerals represent similar structures throughout the several views of the drawings, and wherein:

Fig. 1 (Prior Art) depicts a circuit for current multiplication;

Fig. 2 depicts an exemplary construct of a current squaring cell, according to an embodiment of the present invention;

Fig. 3 depicts a first embodiment of a current squaring cell according to the present invention;

Fig. 4 depicts an exemplary circuit implementation of the first embodiment of current squaring cell;

Fig. 5 depicts a second embodiment of a current squaring cell;

Fig. 6 depicts an exemplary circuit implementation of the second embodiment;

Figs. 7A - 7D provide plots of current waveforms at different locations of a current squaring cell with respect to an input signal at a rate of 200 MHz; and

Figs. 8A - 8D provide plots of current waveforms at different locations of a current squaring cell with respect to an input signal at a rate of 2 GHz.

**DETAILED DESCRIPTION**

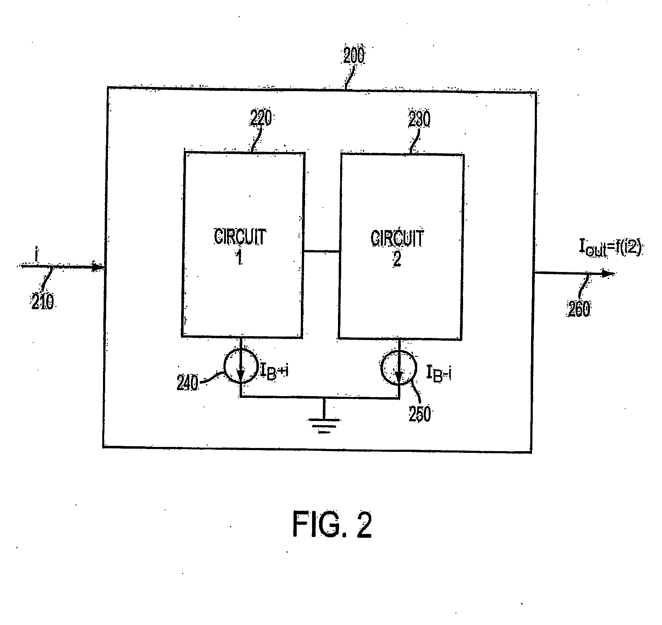

Fig. 2 depicts an exemplary circuit construct of a current squaring cell 200, according to an embodiment of the present invention. The circuit construct 200 receives, as an input, a current i 210 and produces, as an output, a current

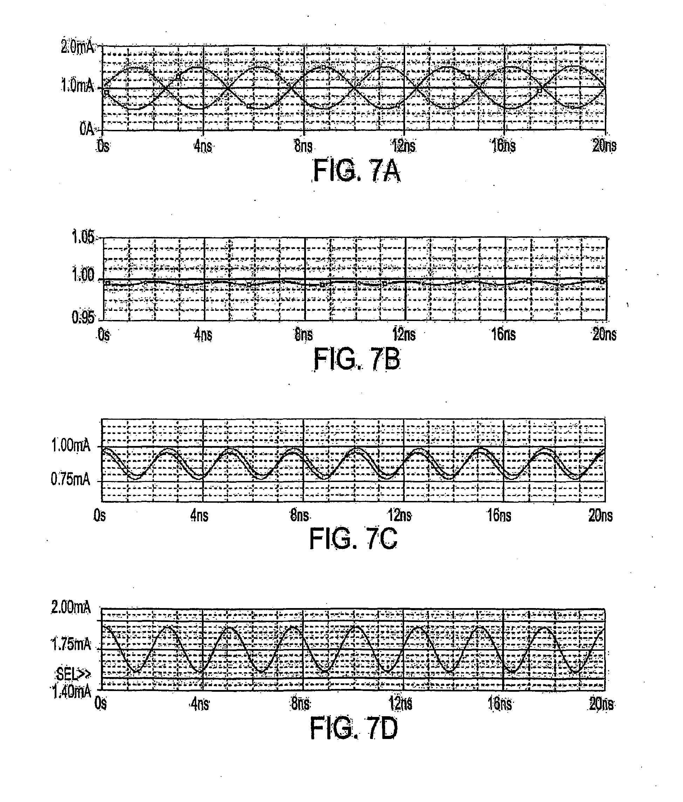

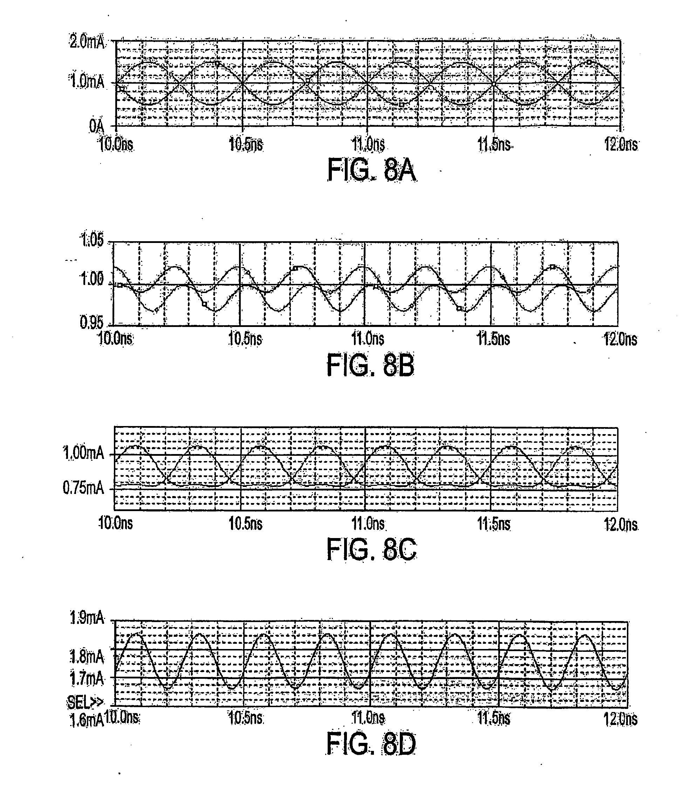

$I_{out}$ 260 corresponding to a function of the squared input current or $f(i^2)$. The circuit construct 200 comprises a first circuit 220, having a first tail current 240 of a magnitude $I_B+i$, and a second circuit 230, having a second tail current 250 of a magnitude $I_B-i$. In this construct, the current $I_B$ represents a constant current source such as a DC quiescent current and i represents a dynamic input current signal. This is illustrated in Figs. 7A and 8A, where the constant line at the level of 1.0mA represents a constant current source $I_B$ and the waveforms in these figures represent the input current signal i. The first circuit 220 and the second circuit 230, the content of which will be described later, are interconnected as shown.

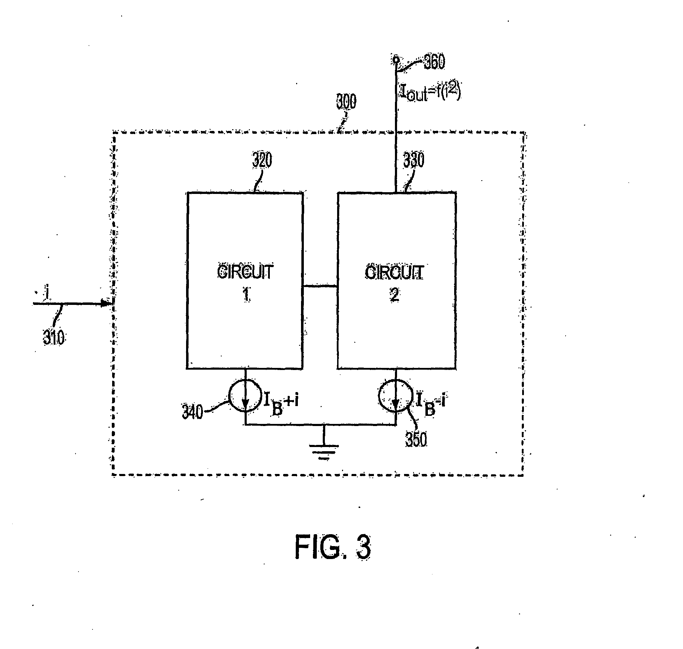

Fig. 3 depicts a current squaring cell 200 according to a first embodiment 300 of the present invention. Embodiment 300 comprises a first circuit 320, having a first tail current 340 of a magnitude $I_B+i$, and a second circuit 330, having a second tail current 350 of a magnitude $I_B-i$, where an output current, $I_{out}$ 360, is produced by the second circuit 330 and is a function of squared input current i at input 310.

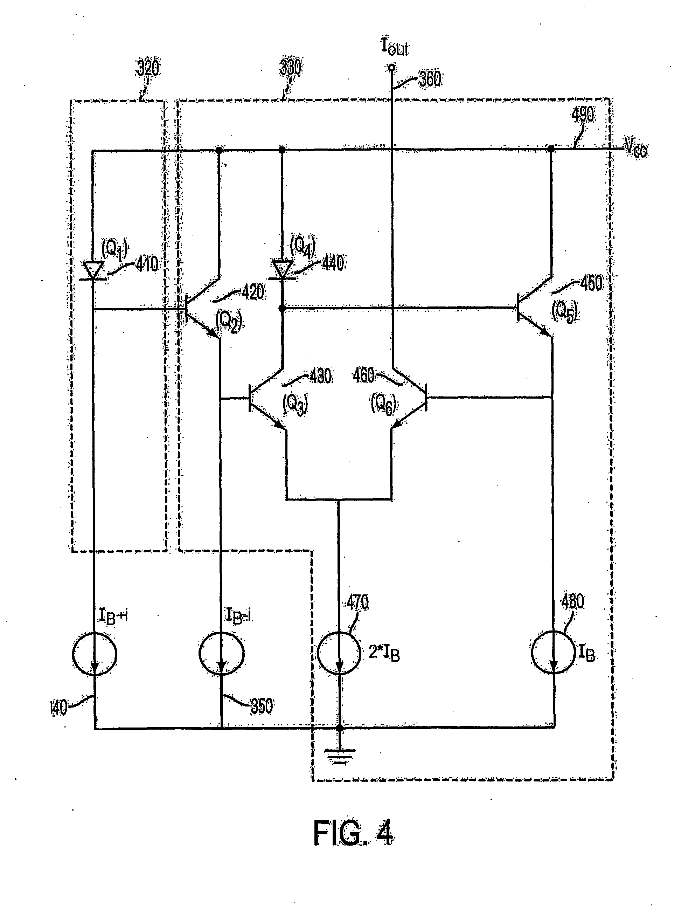

Fig. 4 depicts an exemplary circuit implementation of embodiment 300 of current squaring cell 200. Circuit 320 of embodiment 300 includes a first component 410 ($Q_1$), which may be realized using a diode having its anode terminal connected to a source of reference voltage Vcc and its cathode terminal connected to the tail current 340 of $I_B+i$, as shown in Fig. 4. Alternatively, the component 410 may be realized using a transistor (not shown) having its base electrode and collector electrode coupled together to connect to the reference voltage Vcc source and its emitter electrode connected to the tail current 340.

Circuit 330 of embodiment 300 comprises a first transistor 420 ($Q_2$), a second transistor 430 ($Q_3$), a second component 440 ($Q_4$), a third transistor 460 ($Q_6$), and a fourth transistor 450 ($Q_5$) interconnected as shown. Similarly, the second component 440 may be realized using either a diode (as shown) or a transistor. When a diode is utilized, its anode terminal may serve as the positive terminal of the second component 440 and its cathode terminal may serve as the negative terminal of the second component 440. When a transistor is utilized, its base electrode and its collector electrode are coupled together connecting to the reference voltage source Vcc and its emitter electrode serve as the negative terminal of the second component 440.

The base electrode of the first transistor 420 is connected to the negative terminal of the first component 410. The collector electrode of the first transistor 420 is connected to the reference voltage source Vcc and the emitter electrode of the first transistor 420 is connected to both the tail current source 350 of $I_B-i$ and the base electrode of the second transistor 430. The collector electrode of the second transistor 430 is connected to the negative terminal of the second component 440, whose positive terminal is connected to the reference voltage source Vcc.

The emitter electrode of the second transistor 430 is coupled with the emitter electrode of the fourth transistor 460 and together are connected to a third tail current 470 that has a constant magnitude of $2*I_B$.

The base electrode of the third transistor 450 is connected to the negative terminal of the second component 440. The emitter electrode of the third transistor 450 is coupled with the base electrode of the fourth transistor 460 and together connecting to a fourth tail current source 480 that has a constant magnitude of $I_B$. The collector electrode of the third transistor 450 is connected to the source of reference voltage Vcc. The collector electrode of the fourth transistor 460 serves as a terminal for the output current 360 $I_{out}$.

The output current $I_{out}$ is a function of the squared input current i. This can be shown from the translinear loop equations as follows. Since the following equalities hold:

$$V_{be1} + V_{be2} + V_{be3} = V_{be4} + V_{be5} + V_{be6}, \quad (4)$$

$$I_{c1} * I_{c2} * I_{c3} = I_{c4} * I_{c5} * I_{c6}, \text{ and} \quad (5)$$

$$I_{out} = I_{c6} = I_{c1} * I_{c2} / I_{c5} \quad (6)$$

where $V_{be1}$ represents the voltage between the positive and the negative terminals of component 410 ($Q_1$); $V_{be2}$ represents the voltage between the base electrode and the emitter electrode of the first transistor 420 ($Q_2$); $V_{be3}$ represents the voltage between the base electrode and the emitter electrode of a second transistor 430 ($Q_3$); $V_{be4}$ represents the voltage between the positive and negative terminals of component 440 ($Q_4$); $V_{be5}$ represents the voltage between the base electrode and the emitter electrode of a third transistor 450 ($Q_5$); and $V_{be6}$ represents the voltage between the base electrode and the emitter electrode of a fourth transistor 460 ($Q_6$). In addition, $I_{c1}$ represents the current at the negative terminal of component 410 ($Q_1$); $I_{c2}$ represents the current at the collector electrode of the first transistor 420 ($Q_2$); $I_{c3}$ represents the current at the collector electrode of the second transistor 430 ($Q_3$); $I_{c4}$ represents the current at the negative terminal of the second component 440 ($Q_4$); $I_{c5}$ represents the current at the collector electrode of the third transistor 450 ($Q_5$); and $I_{c6}$ represents the current at the collector electrode of the fourth transistor 460 ($Q_6$). Since $I_{c1} = I_B + i$, $I_{c2} = I_B - i$, and $I_{c5} = I_B$, by substitution, one can derive the following:

$$I_{out} = (I_B + i) * (I_B - i) / I_B = (I_B^2 - i^2) / I_B = I_B - i^2 / I_B. \quad (7)$$

That is, the output current of the second circuit 330 is a function of squared input current i. In addition, when $I_B$ is a zero-TC current source, the output current $I_{out}$ is also independent of temperature.

The above characteristics hold when the frequency of the input signal i is within a certain frequency range. When frequency increases, the negative terminal of the first component 410 ($Q_1$) connected to the first tail current ($I_B + i$) and the emitter electrode of the first transistor 420 ($Q_2$) connected to the second tail current ($I_B - i$) may observe different impedances. Consequently, the current flow to component 410 ($I_{c1}$) may differ from the current flow to the first transistor 420 ($I_{c2}$) in terms of both amplitude and in phase delays. The higher the frequency, the larger the difference may be. This can be seen from the following. The input signal i may generally take a form of i = $I_0 * \cos(\omega t)$ and the expressions of $I_{c1} = I_B + i$ and $I_{c2} = I_B - i$ may then be expanded as:

$$I_{c1} = a * \{ I_B + I_0 * \cos(\omega t + \Phi_1) \}, \quad (8)$$

$$I_{c2} = b * \{ I_B + I_0 * \cos(\omega t + \Phi_2) \}, \quad (9)$$

where $\Phi_1$ and $\Phi_2$ represent the phase of the signals.

As a consequence, the product of $I_{c1}$ and $I_{c2}$ may include both a fundamental frequency as well as an additive DC current component which is a function of both the amplitude of the input signal i ($I_0$) and the phase difference ($\Phi_1 - \Phi_2$) occurring at a certain frequency. That is,

$$I_{c1} * I_{c2} = a * b * (I_B^2 - i^2) + c * i + \text{additive DC current} (I_0, \Phi_1 - \Phi_2) \quad (10)$$

In addition to this discrepancy, the assumed condition $I_{c3} = I_{c4}$ may not hold at a high frequency. When the frequency of the input signal i is increased, the current observed at the negative terminal of the second component 440 may be delayed compared with the current at the collector electrode of the second transistor 430. This may also result in bleeding of a signal at the fundamental frequency into the output signal 360.

Furthermore, when the input signal i has a magnitude that is comparable to that of $I_B$, component 410 (which has the first tail current $I_B + i$) and the first transistor 420 (whose emitter electrode is connected to the second tail current $I_B - i$) may behave quite differently during both positive and negative cycles of the input current i. This may be due to the difference in resistance measured between the negative terminal of the first component 410 and the emitter electrode of the first transistor 420.

Although embodiment 300 may produce an output current 360 as a function of the squared input current i, it may not behave as such when the above conditions no longer hold in high frequency input situations. In situations where the input current signal is of high frequency, another embodiment 500 of current squaring cell 200, described below, may be employed.

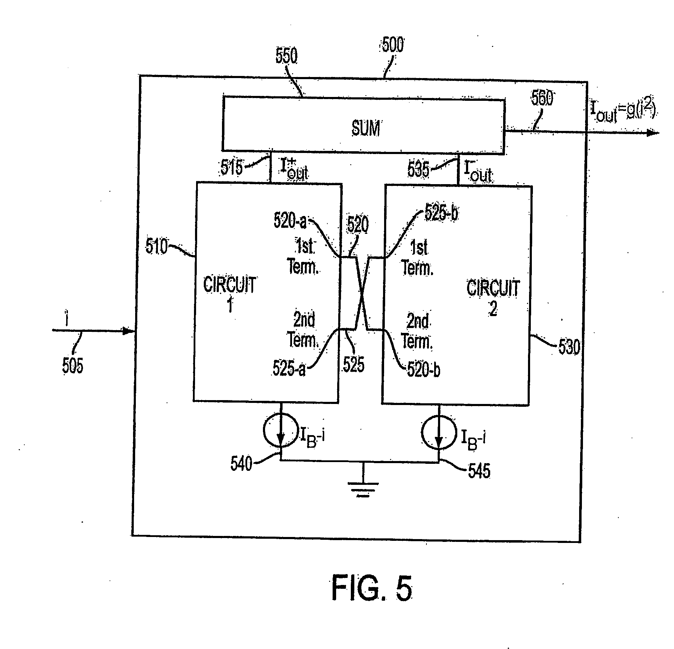

Referring to Fig. 5, embodiment 500 comprises a first circuit 510, having a first tail current 540 of magnitude $I_B + i$ and a first output current 515 $I^+_{out}$, a second circuit 530, having a second tail current 545 of magnitude $I_B - i$ and a second output current 535 $I^-_{out}$, and a sum circuit 550. The first circuit 510 receives an input current signal i 505 and produces the output current $I^+_{out}$, which is a function of the squared input current signal i. Similarly, circuit 530 receives an input current signal i 505 and produces output current $I^-_{out}$, which is a function of the squared input current signal i.

The sum circuit 550 receives both the first output current 515 $I^+_{out}$ of the circuit 510 and the second output current 535 $I^-_{out}$ of circuit 530 and produces an output current 560 $I_{out}$. The output current 560 may be represented as $I_{out} = g(I^+_{out}, I^-_{out})$ and the function g may be designed so that the output current 560 $I_{out}$ remains a function of the squared input current signal, e.g., $g(I^+_{out}, I^-_{out}) = I^+_{out} + I^-_{out}$ which is the sum of the two inputs.

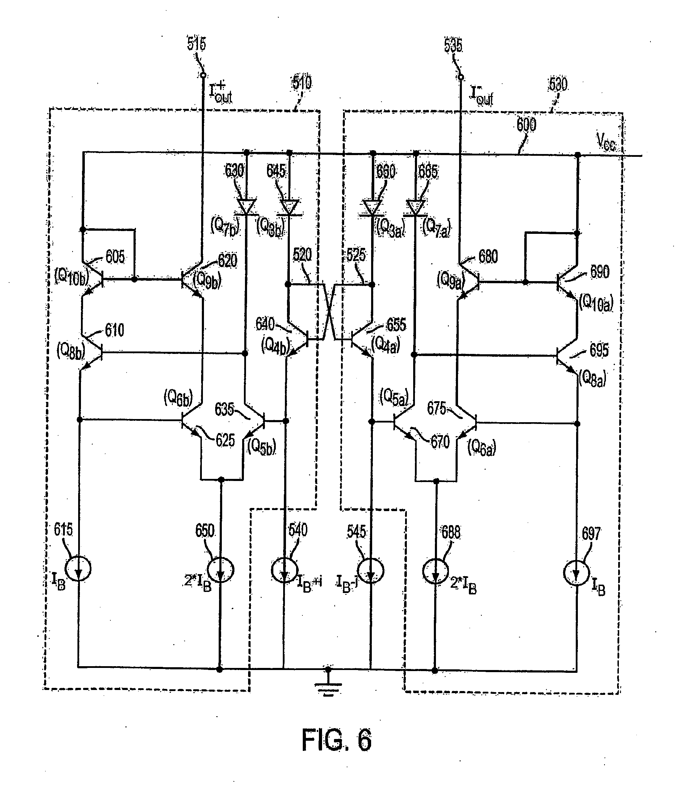

Circuit 510 and circuit 530 may be coupled through connections 520 and 525. Circuit 510 and circuit 530 may be realized using symmetric circuitry, each of which has two connecting terminals. For example, circuit 510 has a first connecting terminal 520-a and a second connecting terminal 525-a. Similarly, circuit 530 has a first connecting terminal 525-b and a second connecting terminal 520-b. When circuit 510 is coupled with circuit 530, the first connecting terminal 520-a of circuit 510 is coupled with the second connecting terminal 520-b of circuit 530 and the second connecting terminal 525-a of circuit 510 is coupled with the first connecting terminal 525-b of circuit 530. This cross connection is shown in Fig. 5 and is made more clear in Fig. 6.

Fig. 6 depicts an exemplary implementation of circuit 510 and circuit 530. The left portion in Fig. 6 shows an exemplary circuitry that implements circuit 510, the right portion of Fig. 6 shows an exemplary circuitry that implements circuit 530. In this embodiment, the internal construct of circuit 510 is a mirror image of the construct of circuit 530 except that the tail current of circuit 510 ($I_B+i$) is different from the tail current of circuit 530 ($I_B-i$).

Circuit 510 comprises a first component 645 ($Q_{3b}$), a first transistor 640 ($Q_{4b}$), a second transistor 635 ($Q_{5b}$), a third transistor 625 ($Q_{6b}$), a second component 630 ($Q_{7b}$), a fourth transistor 620 ($Q_{9b}$), a fifth transistor 610 ($Q_{8b}$), and a sixth transistor 605 ($Q_{10b}$), interconnected as shown. The first and/or the second components 645 and 630 may be realized using a diode (as shown in Fig. 6) with its anode terminal serving as the positive terminal and its cathode terminal serving as the negative terminal of first and second components 645 and 630. Alternatively, a transistor may be employed to realize the first and/or second components 645 and 630 (not shown), where the base electrode and the collector electrode of such a transistor are coupled together to serve as the positive terminal and its emitter electrode serves as the negative terminal of the first and/or second components 645 and 630.

The positive terminal of the first component 645 is connected to a reference voltage Vcc source and the negative terminal of the first component 645 is connected to the collector electrode of the first transistor 640. The emitter electrode of the first transistor 640 is connected to the first tail current ($I_B+i$) 540 as well as the base electrode of the second transistor 635. The collector electrode of the second transistor 635 is connected to the negative terminal of the second component 630 whose positive terminal is connected to the reference voltage Vcc 600. The emitter electrode of the second transistor 635 is coupled with the emitter electrode of the third transistor 625 and together connected to a third tail current 650 with a current strength of $2*I_B$. The third transistor 625 is connected with the fourth transistor 620 in a serial fashion with the collector electrode of the third transistor 625 coupled with the emitter electrode of the fourth transistor 620. The collector electrode of the fourth transistor 620 corresponds to the first output current 515 $I^+_{out}$.

The fifth transistor 610 and the sixth transistor 605 are connected in a serial manner between the reference voltage Vcc 600 and a fourth tail current 615 with a current strength of $I_B$. As shown in Fig. 6, the collector electrode of the fifth transistor 610 is coupled with the emitter electrode of the sixth transistor 605, whose collector electrode is connected to the reference voltage Vcc 600. The base electrode of the fifth transistor 610 is connected to the collector electrode of the second transistor 635 and the base electrode of the sixth transistor 605 is coupled both with its own collector electrode and with the base electrode of the fourth transistor 620.

Circuit 530 comprises a third component 660 ($Q_{3a}$), a seventh transistor 655 ($Q_{4a}$), an eighth transistor 670 ($Q_{5a}$), a ninth transistor 675 ($Q_{6a}$), a fourth component 665 ($Q_{7a}$), a tenth transistor 680 ($Q_{9a}$), an eleventh transistor 695 ($Q_{8a}$), and a twelfth transistor 690 ($Q_{10a}$). As mentioned, circuit 530 is a mirror image of circuit 510. The third component 660 corresponds to the first component 645 and the fourth component 665 corresponds to the second component 630. Similarly, the seventh transistor 655 corresponds to the first transistor 640 except that the emitter of the seventh transistor is connected to the second tail current ($I_B-i$) 545; the eighth transistor 670 corresponds to the second transistor 635; the ninth transistor 675 corresponds to the third transistor 625; the tenth transistor 680 corresponds to the fourth transistor 620; the eleventh transistor 695 corresponds to the fifth transistor 610; the twelfth transistor 690 corresponds to the sixth transistor 605. The corresponding parts of circuit 510 and circuit 530 are also similarly connected.

Circuit 510 and circuit 530, the contents of which are described later, are interconnected as shown. The collector electrode of the first transistor 640 (which also connects to the negative terminal of the first component 645) serves as the first connection terminal 520-a of circuit 510 (Fig. 5). The base electrode of the first transistor 640 serves as the second connection terminal 525-a of circuit 510. Similarly, the collector electrode of the seventh transistor 655 (which also connects to the negative terminal of the third component 660) serves as the first connection terminal 525-b of circuit 530 and the base electrode of the seventh transistor 655 serves as the second connection terminal 520-b of circuit 530.

The exemplary implementation circuitry 500 has the following characteristics, referring to its translinear loop equations:

$$V_{Q3a} + V_{Q4b} + V_{Q5b} = V_{Q7b} + V_{Q8b} + V_{Q6b}, \quad (11)$$

$$V_{Q3b} + V_{Q4a} + V_{Q5a} = V_{Q7a} + V_{Q8a} + V_{Q6a}, \quad (12)$$

$$I_{Q3a} * I_{Q4b} * I_{Q5b} = I_{Q7b} * I_{Q8b} * I_{Q9b}, \qquad (13)$$

$$I_{Q3b} * I_{Q4a} * I_{Q5a} = I_{Q7a} * I_{Q8a} * I_{Q9a}, \qquad (14)$$

That is, circuit 510, when considered together with the third component 660, the seventh transistor 655, and the second tail current ($I_B$ - i) 545, has the same properties as the circuit shown in Fig. 4. Similarly, circuit 530, when considered together with the first component 645, the first transistor 640, and the first tail current ($I_B$ + i) 540, has the same properties as the circuit shown in Fig. 4. Therefore, the first output current 515 $I^+_{out}$ and the second output current 535 $I^+_{out}$ are both a function of the squared input current i.

The sum circuit 550 may linearly combine the first and second output currents, for example, using a summation. Such a linear combination of the first output current 515 $I^+_{out}$ of circuit 510 and the second output current 535 $I^-_{out}$ of circuit 530 produces the output current 560 $I_{out}$, which is also a function of the squared input current signal i.

As can be seen, in the second embodiment 500 of current squaring cell, by using balanced or symmetric current squaring cells, the additive DC current and the signal at the fundamental frequency at the first output current $I^+_{out}$ and the second output current $I^-_{out}$, although having the same amplitudes, are out of phase with respect to each other. The impact of high frequencies on the additive DC current and the signal at the fundamental frequency are canceled out when the first output current $I^+_{out}$ and the second output current $I^-_{out}$ are combined at the sum circuit 550. In this way, the expected relationship under the square law is maintained even under high frequency situations. Notably, in the exemplary implementation as shown in Fig. 6, the first tail current source ($I_B$ + i) 540 and the second tail current source ($I_B$ - i) 545 are loaded by the same impedance. In addition, the impact of positive and negative cycles (that exist when the amplitude of input current i is comparable to that of $I_B$) on circuit 510 and circuit 530 is also canceled out when $I^+_{out}$ and $I^-_{out}$ are combined.

In addition, it is known that the square law relationship, as discussed above, holds when the effect of limited early voltages is assumed to be negligible. This assumption, however, may not hold when input signal frequency is high, in which case a voltage may not arise high enough in a short period of time to avoid the early voltage impact. The second embodiment 500 of current squaring cell also exhibits the characteristic of canceling such early voltage impact. This is due to the additional use of the fourth and the sixth transistors 620 and 605 in circuit 510 as well as the tenth and the twelfth transistors 680 and 690 in circuit 530.

In the exemplary circuit implementation shown in Fig. 4, assuming $V_{ce1}$ = $1*V_{be}$, where $V_{ce1}$ represents the voltage between the collector and emitter electrodes of the first electronic component ($Q_1$) (in the circuit shown, it is between the anode terminal and cathode terminal of a diode), the following relationships exist:

$$V_{ce1} = 1*V_{be} \; ; \quad (15)$$

$$V_{ce2} = 2*V_{be} \; ; \quad (16)$$

$$V_{ce3} = 2*V_{be} \; ; \quad (17)$$

$$V_{ce4} = 1*V_{be} \; ; \quad (18)$$

$$V_{ce5} = 2*V_{be} \; ; \quad (19)$$

where the voltage $V_{ce6}$ between the collector and emitter electrodes of $Q_6$ (or the fourth transistor 450) depends on output loading. However, based on part of the circuit as shown in Fig. 6, we now have:

$$V_{ce3b} = 1 * V_{be} ; \quad (20)$$

$$V_{ce4a} = 1 * V_{be} ; \quad (21)$$

$$V_{ce5a} = 2 * V_{be} ; \quad (22)$$

$$V_{ce7a} = 1 * V_{be} ; \quad (23)$$

$$V_{ce8a} = 1 * V_{be} ; \quad (24)$$

$$V_{ce6a} = 2 * V_{be} \quad (25)$$

where $V_{ce3b}$ represents the voltage between the two terminals of component $Q_{3b}$ (the first component 645), $V_{ce4a}$ represents the voltage between the collector and emitter electrodes of $Q_{4a}$ (the seventh transistor 655), etc. As can be seen, within the translinear loop formed by $Q_{3b}$, $Q_{4a}$, $Q_{5a}$, $Q_{7a}$, $Q_{8a}$, and $Q_{6a}$, corresponding components pairs ($Q_{3b}$-$Q_{7a}$, $Q_{4a}$-$Q_{8a}$, and $Q_{5a}$-$Q_{6a}$) all have matched voltages. Notably, the voltage $V_{ce6}$ now no longer depends on the output loading. Therefore, the impact of limited Early voltage may be eliminated.

Figs. 7A - 7D provide plots of current measurements made at different locations of the current squaring cell circuit shown in Fig. 6 when the input signal i has a frequency of 200 MHz. Fig. 7A shows the waveforms of the first tail current ($I_B + i$) and the second tail current ($I_B - i$), where $I_B$ is shown at a constant level of 1.0mA and the amplitude of the input current signal i is around |0.5mA|.

Fig. 7B shows that the current flowing through the fourth component 665 and the current measured at the collector electrode of the eighth transistor 670 are almost identical when the frequency is 200 MHz. In Fig. 7B, the first plotted curve (marked by a square) represents the ratios of the current flowing through the fourth component 665 to that of the eighth transistor 670 and it can be seen that the ratios on the curve are quite close to 1.0. Similarly, the second plotted curve (marked by a diamond shape) represents the ratios of the current flowing through the second component 630 to that of the second transistor 635 and it can be seen that the ratios on the curve are also quite close to 1.0.

Fig. 7C shows two plotted curves representing the amplitudes of the first output current $I^+_{out}$ and that of the second output current $I^-_{out}$, respectively. It can be seen that at a low frequency, the two output currents present similar circuit behavior, having substantially the same amplitudes and phases. Fig. 7D shows a curve representing the combined output current $I_{out}$ that is a sum of the two output currents and is a function of the squared input current signal.

Figs. 8A - 8D provide plots of current measurements made at different locations of the current squaring cell circuit shown in Fig. 6 when the input signal i has a high frequency of 2 GHz. Fig. 8A shows the curves representing both the first tail current ($I_B + i$) 540 and second tail current ($I_B - i$) 545.

Fig. 8B shows two curves. The one marked with a square represents ratios of the current flowing through the fourth component 665 to that of the eighth transistor 670. It can be seen that most of the ratio values along the first curve are not close to 1.0. That is, at a high frequency of 2 GHz, the currents measured at the positive terminal of the fourth component 665 and at the collector electrode of the eighth transistor 670 no longer have the same phase and amplitude with respect to a given time. The second curve (marked by a diamond shape) represents ratios of the current flowing through the second component 630 to that measured at the collector electrode of the second transistor 635. Similarly, at a high frequency of 2 GHz, the current measured at the positive terminal of the second component 630 and that measured at the collector electrode of the second transistor 635 differ in phases and amplitudes.

Fig. 8C shows two plotted curves representing the amplitudes of the first output current $I^+_{out}$ and that of the second output current $I^-_{out}$, respectively. It can be seen that at a high frequency, circuit 510 and circuit 530 behave quite differently because of the impact of positive and negative cycles of the input current signal i. For example, the impact of the $I_B + i$ is quite different from the impact of $I_B - i$. This is especially evident from the observation that neither of the first output current $I^+_{out}$ or the second output current $I^-_{out}$ maintains a proper waveform as a function of the input waveform as shown in Fig. 8A.

Fig. 8D shows a curve representing the combined output current $I_{out}$ that is a sum of the two output currents and is a function of the squared input current signal. As seen in Fig. 8D, by combining the first output current $I^+_{out}$ and the second output current $I^-_{out}$, the negative impact on both the first output current $I^+_{out}$ and the second output current $I^-_{out}$ is canceled out so that the overall output current $I_{out}$ still presents a proper behavior as a function of the squared input current signal i.

## Claims

1. A squaring cell (200; 300; 500), comprising:

   a first circuit portion (220; 320; 510) and a second circuit portion (230; 330; 530) connected to the first circuit portion (220; 320; 510), **characterized in that**
   the first circuit portion (220; 320; 510) receives a first tail current (240; 340; 540) positively proportional to an input signal current i (210; 310; 505); and
   the second circuit portion (230; 330; 530) receives a second tail current (250; 350; 545) negatively proportional to the input signal current i (210; 310; 505),
   the first (220; 320; 510) and second (230; 330; 530) circuit portions being operative to produce an output current lout (260; 360; 560) of the squaring cell proportional to a product of the first (240; 340; 540) and second (250; 350; 545) tail currents; wherein
   the output current lout (260; 360; 560) correlates with the square of the input signal current i (210; 310; 505).

2. The squaring cell (200; 300; 500) of claim 1, wherein the output current $I_{out}$ (260; 360; 560) is responsive to the first tail current (240; 340; 540) and the second tail current (250; 350; 545).

3. The squaring cell (200; 300; 500) of claim 2, wherein
   the first tail current (240; 340; 540) is a summation of a DC quiescent current $I_B$ and the input signal current i (210; 310; 505); and
   the second tail current (250; 350; 545) is a subtraction between the DC quiescent current $I_B$ and the input signal current i (210; 310; 505).

4. The squaring cell (200; 300) of claim 3, wherein
   the first circuit portion (220; 320) comprises a first component (410) with a first positive terminal and a first negative terminal where the first negative terminal receives the first tail current (240; 340) and the first positive terminal connects to a reference voltage Vcc; and
   the second circuit portion (230; 330) comprises:

   a first transistor (420) with its emitter electrode receiving the second tail current (250; 350), its base electrode connected to the negative terminal of the first component (410), and its collector electrode connected to the reference voltage Vcc,
   second (430) and third (450) transistors having emitter electrodes thereof coupled together receiving a first constant current, wherein the base electrode of the second transistor (430) is connected to the emitter electrode of the first transistor (420) and the collector electrode of the third transistor (450) is connected to the output current $I_{out}$ (260; 360),
   a second component (440) with a positive terminal and a negative terminal, where the negative terminal is connected to the collector electrode of the second transistor (430) and the positive terminal is connected to the reference voltage Vcc, and
   a fourth transistor (460) having its base electrode connected to the collector electrode of the second transistor (430), its emitter electrode coupled with the base electrode of the third transistor (450) receiving a second constant current, and its collector electrode connected to the reference voltage Vcc.

5. The squaring cell (200; 300) of claim 4, wherein the first component (410) and/or the second component (440) include one of:

   a diode with its anode terminal serving as a positive terminal and its cathode terminal serving as a negative terminal; and

a transistor with its base electrode and its collector electrode coupled together, where the emitter electrode serves as a negative terminal and the collector electrode as a positive terminal.

6. The squaring cell (200; 300) of claim 4, wherein the first constant current is twice that of the DC quiescent current $I_B$.

7. The squaring cell (200; 300) of claim 4, wherein the second constant current is the same as the DC quiescent current $I_B$.

8. The squaring cell (200; 500) of claim 3, wherein the output current $I_{out}$ (260; 560) of the squaring cell (200; 500) is a summation of a first output current (515) of the first circuit portion (220; 510) and a second output current (535) of the second circuit portion (230; 530).

9. The squaring cell (200; 500) of claim 8, wherein first output current (515) correlates with the square of the input signal current i (210; 505).

10. The squaring cell (200; 500) of claim 8, wherein the second output current (535) correlates with the square of the input signal current i (210; 505).

11. The squaring cell (200; 500) of claim 8, wherein the first circuit portion (220; 510) comprises:

a first transistor (640) with its emitter electrode receiving the first tail current (240; 540) and its base electrode connected to the second circuit portion (230; 530);
a first component (645) with a first positive terminal and a first negative terminal having the first negative terminal connected to the collector electrode of the first transistor (640) and the first positive terminal connected to a reference voltage Vcc;
second (635) and third (625) transistors having emitter electrodes thereof coupled together receiving a first constant current, wherein the base electrode of the second transistor (635) is connected to the emitter electrode of the first transistor (640);
a second component (630) with a second positive terminal and a second negative terminal having the second negative terminal connected to the collector electrode of the second transistor (635) and the second positive terminal connected to the reference voltage Vcc;
a fourth transistor (620) having its collector electrode connected to the first output current (515) and its emitter electrode connected to the collector electrode of the third transistor (625); and
fifth (610) and sixth (605) transistors connected in a serial manner having the emitter electrode of the sixth transistor (605) connected with the collector electrode of the fifth transistor (610), where the base electrode of the fifth transistor (610) is connected to the collector electrode of the second transistor (635), the emitter electrode of the fifth transistor (610) receives a second constant current, and the base electrode of the sixth transistor (605) is coupled with both the collector electrode of the sixth transistor (605) and the base electrode of the fourth transistor (620), together connecting to the reference voltage Vcc.

12. The squaring cell (200; 500) of claim 11, wherein the first component (645) and/or the second component (630) include one of:

a diode with its anode terminal serving as a positive terminal and its cathode terminal as a negative terminal; and
a transistor with its base electrode and its collector electrode coupled together, where the emitter electrode serves as a negative terminal and the collector electrode as a positive terminal.

13. The squaring cell (200; 500) of claim 11, wherein the second part (220; 530) comprises:

a seventh transistor (655) with its emitter electrode receiving the second tail current (250; 545), its base electrode connected to the collector electrode of the first transistor (640), and its collector electrode connected to the base electrode of the first transistor (640) of the first part (220; 510);
a third component (660) with a third positive terminal and a third negative terminal having the third negative terminal connected to the collector electrode of the seventh transistor (655) and the third positive terminal connected to the reference voltage Vcc;
eighth (670) and ninth (675) transistors having emitter electrodes thereof coupled together receiving a third constant current, wherein the base electrode of the eighth transistor (670) is connected to the emitter electrode of the seventh transistor (655);

a fourth component (665) with a fourth positive terminal and a fourth negative terminal having the fourth negative terminal connected to the collector electrode of the eighth transistor (670) and the fourth positive terminal connected to the reference voltage Vcc;

a tenth transistor (680) having its collector electrode connected to the second output current (535) and its emitter electrode connected to the collector electrode of the ninth transistor (675); and

eleventh (695) and twelfth (690) transistors connected in a serial manner having the emitter electrode of the twelfth transistor (690) connected with the collector electrode of the eleventh transistor (695), where the base electrode of the eleventh transistor (695) is connected to the collector electrode of the eighth transistor (670), the emitter electrode of the eleventh transistor (695) receives a fourth constant current, and the base electrode of the twelfth transistor (690) is coupled with both the collector electrode of the twelfth transistor (690) and the base electrode of the tenth transistor (680), together connecting to the reference voltage Vcc.

**14.** The squaring cell (200; 500) of claim 13, wherein the third component (660) and/or the fourth component (665) include one of:

a diode with its anode terminal serving as a positive terminal and its cathode terminal as a negative terminal; and

a transistor with its base electrode and its collector electrode coupled together, where the emitter electrode serves as a negative terminal and the collector electrode as a positive terminal.

**15.** The squaring cell (200; 500) of claim 13, wherein the first or the third constant current is twice that of the DC quiescent current $I_B$.

## Patentansprüche

**1.** Quadrierzelle (200; 300; 500), umfassend:

einen ersten Schaltungsabschnitt (220; 320; 510) und einen zweiten Schaltungsabschnitt (230; 330; 530), der mit dem ersten Schaltungsabschnitt (220; 320; 510) verbunden ist, **dadurch gekennzeichnet, dass**

der erste Schaltungsabschnitt (220; 320; 510) einen ersten Tailstrom (240; 340; 540) positiv proportional zu einem Eingangssignalstrom i (210; 310, 505) empfängt; und

der zweite Schaltungsabschnitt (230; 330; 530) einen zweiten Tailstrom (250; 350; 545) negativ proportional zu dem Eingangssignalstrom i (210; 310, 505) empfängt,

wobei der erste (220; 320; 510) und der zweite (230; 330; 530) Schaltungsabschnitt betriebsfähig sind, um einen Ausgangsstrom $I_{out}$ (260; 360; 560) der Quadrierzelle proportional zu einem Produkt des ersten (240; 340; 540) und des zweiten (250; 350; 545) Tailstroms zu erzeugen; wobei

der Ausgangsstrom $I_{out}$ (260; 360; 560) mit dem Quadrat des Eingangssignalstroms i (210; 310, 505) korreliert.

**2.** Quadrierzelle (200; 300; 500) nach Anspruch 1, wobei der Ausgangsstrom $I_{out}$ (260; 360; 560) auf den ersten Tailstrom (240; 340; 540) und den zweiten Tailstrom (250; 350; 545) anspricht.

**3.** Quadrierzelle (200; 300; 500) nach Anspruch 2, wobei

der erste Tailstrom (240; 340; 540) eine Summierung eines DC-Ruhestroms $I_B$ und des Eingangssignalstroms i (210; 310, 505) ist; und

der zweite Tailstrom (250; 350; 545) eine Subtraktion zwischen dem DC-Ruhestrom $I_B$ und dem Eingangssignalstrom i (210; 310, 505) ist.

**4.** Quadrierzelle (200; 300) nach Anspruch 3, wobei

der erste Schaltungsabschnitt (220; 320) eine erste Komponente (410) mit einem ersten positiven Anschluss und einem ersten negativen Anschluss umfasst, wo der erste negative Anschluss den ersten Tailstrom (240; 340) empfängt bzw. aufnimmt und der erste positive Anschluss zu einer Referenzspannung Vcc verbindet bzw. mit dieser verbunden ist; und

der zweite Schaltungsabschnitt (230; 330) umfasst:

einen ersten Transistor (420), bei dem seine Emitterelektrode den zweiten Tailstrom (250; 350) empfängt bzw. aufnimmt, seine Basiselektrode zu dem negativen Anschluss der ersten Komponente (410) verbindet bzw. mit diesem verbunden ist und seine Kollektorelektrode zu der Referenzspannung Vcc verbindet bzw. mit dieser verbunden ist,

einen zweiten (430) und einen dritten (450) Transistor, bei denen Emitterelektroden davon miteinander gekoppelt sind, die einen ersten konstanten Strom empfangen bzw. aufnehmen, wobei die Basiselektrode des zweiten Transistors (430) mit der Emitterelektrode des ersten Transistors (420) verbunden ist und die Kollektorelektrode des dritten Transistors (450) mit dem Ausgangsstrom $I_{out}$ (260; 360) verbunden ist,

eine zweite Komponente (440) mit einem positiven Anschluss und einem negativen Anschluss, wo der negative Anschluss mit der Kollektorelektrode des zweiten Transistors (430) verbunden ist und der positive Anschluss mit der Referenzspannung Vcc verbunden ist, und

einen vierten Transistor (460), bei dem seine Basiselektrode mit der Kollektorelektrode des zweiten Transistors (430) verbunden ist, seine Emitterelektrode mit der Basiselektrode des dritten Transistors (450) gekoppelt ist, die einen zweiten konstanten Strom empfängt bzw. aufnimmt, und seine Kollektorelektrode mit der Referenzspannung Vcc verbunden ist.

5. Quadrierzelle (200; 300) nach Anspruch 4, wobei die erste Komponente (410) und/oder die zweite Komponente (440) eines enthalten:

eine Diode, bei der ihr Anodenanschluss als ein positiver Anschluss dient und ihr Kathodenanschluss als ein negativer Anschluss dient; und

einen Transistor, bei dem seine Basiselektrode und seine Kollektorelektrode miteinander gekoppelt sind, wo die Emitterelektrode als ein negativer Anschluss dient und die Kollektorelektrode als ein positiver Anschluss dient.

6. Quadrierzelle (200; 300) nach Anspruch 4, wobei der erste konstante Strom das Zweifache des DC-Ruhestroms $I_B$ ist.

7. Quadrierzelle (200; 300) nach Anspruch 4, wobei der zweite konstante Strom das gleiche wie der DC-Ruhestrom $I_B$ ist.

8. Quadrierzelle (200; 500) nach Anspruch 3, wobei der Ausgangsstrom $I_{out}$ (260; 560) der Quadrierzelle (200; 500) eine Summierung eines ersten Ausgangsstroms (515) des ersten Schaltungsabschnitts (220; 510) und eines zweiten Ausgangsstroms (535) des zweiten Schaltungsabschnitts (230; 530) ist.

9. Quadrierzelle (200; 500) nach Anspruch 8, wobei der erste Ausgangsstrom (515) mit dem Quadrat des Eingangssignalstroms i (210; 505) korreliert.

10. Quadrierzelle (200; 500) nach Anspruch 8, wobei der zweite Ausgangsstrom (535) mit dem Quadrat des Eingangssignalstroms i (210; 505) korreliert.

11. Quadrierzelle (200; 500) nach Anspruch 8, wobei der erste Schaltungsabschnitt (220; 510) umfasst:

einen ersten Transistor (640), bei dem seine Emitterelektrode den ersten Tailstrom (240; 540) empfängt bzw. aufnimmt und seine Basiselektrode mit dem zweiten Schaltungsabschnitt (230; 530) verbunden ist;

eine erste Komponente (645) mit einem ersten positiven Anschluss und einem ersten negativen Anschluss, bei welcher der erste negative Anschluss mit der Kollektorelektrode des ersten Transistors (640) verbunden ist und der erste positive Anschluss mit einer Referenzspannung Vcc verbunden ist;

einen zweiten (635) und einen dritten (625) Transistor, bei denen Emitterelektroden davon miteinander gekoppelt sind, die einen ersten konstanten Strom empfangen bzw. aufnehmen, wobei die Basiselektrode des zweiten Transistors (635) mit der Emitterelektrode des ersten Transistors (640) verbunden ist;

eine zweite Komponente (630) mit einem zweiten positiven Anschluss und einem zweiten negativen Anschluss, bei welcher der zweite negative Anschluss mit der Kollektorelektrode des zweiten Transistors (635) verbunden ist und der zweite positive Anschluss mit der Referenzspannung Vcc verbunden ist;

einen vierten Transistor (620), bei dem seine Kollektorelektrode mit dem ersten Ausgangsstrom (515) verbunden ist und seine Emitterelektrode mit der Kollektorelektrode des dritten Transistors (625) verbunden ist; und

einen fünften (610) und einen sechsten (605) Transistor, die auf serielle Weise verbunden sind, bei denen die Emitterelektrode des sechsten Transistors (605) mit der Kollektorelektrode des fünften Transistors (610) verbunden ist, wo die Basiselektrode des fünften Transistors (610) mit der Kollektroelektrode des zweiten Transistors (635) verbunden ist, die Emitterelektrode des fünften Transistors (610) einen zweiten konstanten Strom empfängt bzw. aufnimmt und die Basiselektrode des sechsten Transistors (605) mit sowohl der Kollektorelektrode des sechsten Transistors (605) als auch der Basiselektrode des vierten Transistors (620) gekoppelt ist, zusammen verbindend zu bzw. verbunden mit der Referenzspannung Vcc.

**12.** Quadrierzelle (200; 500) nach Anspruch 11, wobei die erste Komponente (645) und/oder die zweite Komponente (630) eines enthalten:

eine Diode, bei der ihr Anodenanschluss als ein positiver Anschluss dient und ihr Kathodenanschluss als ein negativer Anschluss dient; und

einen Transistor, bei dem seine Basiselektrode und seine Kollektorelektrode miteinander gekoppelt sind, wo die Emitterelektrode als ein negativer Anschluss dient und die Kollektorelektrode als ein positiver Anschluss dient.

**13.** Quadrierzelle (200; 500) nach Anspruch 11, wobei der zweite Teil (220; 530) umfasst:

einen siebten Transistor (655), bei dem seine Emitterelektrode den zweiten Tailstrom (250; 545) empfängt bzw. aufnimmt, seine Basiselektrode mit der Kollektorelektrode des ersten Transistors (640) verbunden ist und seine Kollektorelektrode mit der Basiselektrode des ersten Transistors (640) des ersten Teils (220; 510) verbunden ist;

eine dritte Komponente (660) mit einem dritten positiven Anschluss und einem dritten negativen Anschluss, bei welcher der dritte negative Anschluss mit der Kollektorelektrode des siebten Transistors (655) verbunden ist und der dritte positive Anschluss mit der Referenzspannung Vcc verbunden ist;

einen achten (670) und einen neunten (675) Transistor, bei denen Emitterelektroden davon miteinander gekoppelt sind, die einen dritten konstanten Strom empfangen bzw. aufnehmen, wobei die Basiselektrode des achten Transistors (670) mit der Emitterelektrode des siebten Transistors (655) verbunden ist;

eine vierte Komponente (665) mit einem vierten positiven Anschluss und einem vierten negativen Anschluss, bei welcher der vierte negative Anschluss mit der Kollektorelektrode des achten Transistors (670) verbunden ist und der vierte positive Anschluss mit der Referenzspannung Vcc verbunden ist;

einen zehnten Transistor (680), bei dem seine Kollektorelektrode mit dem zweiten Ausgangsstrom (535) verbunden ist und seine Emitterelektrode mit der Kollektorelektrode des neunten Transistors (675) verbunden ist; und

einen elften (695) und einen zwölften (690) Transistor, die auf serielle Weise verbunden sind, bei denen die Emitterelektrode des zwölften Transistors (690) mit der Kollektorelektrode des elften Transistors (695) verbunden ist, wo die Basiselektrode des elften Transistors (695) mit der Kollektorelektrode des achten Transistors (670) verbunden ist, die Emitterelektrode des elften Transistors (695) einen vierten konstanten Strom empfängt und die Basiselektrode des zwölften Transistors (690) mit sowohl der Kollektorelektrode des zwölften Transistors (690) als auch der Basiselektrode des zehnten Transistors (680) verbunden ist, zusammen verbindend zu bzw. verbunden mit der Referenzspannung Vcc.

**14.** Quadrierzelle (200; 500) nach Anspruch 13, wobei die dritte Komponente (660) und/oder die vierte Komponente (665) eines enthalten:

eine Diode, bei der ihr Anodenanschluss als ein positiver Anschluss dient und ihr Kathodenanschluss als ein negativer Anschluss dient; und

einen Transistor, bei dem seine Basiselektrode und seine Kollektorelektrode miteinander gekoppelt sind, wo die Emitterelektrode als ein negativer Anschluss dient und die Kollektorelektrode als ein positiver Anschluss dient.

**15.** Quadrierzelle (200; 500) nach Anspruch 13, wobei der erste oder der dritte konstante Strom das Zweifache des DC-Ruhestroms $I_B$ ist.

**Revendications**

**1.** Cellule d'élévation au carré (200 ; 300 ; 500) comprenant :

une première portion de circuit (220 ; 320 ; 510) et une seconde portion de circuit (230 ; 330 ; 530) connectée à la première portion de circuit (220 ; 320 ; 510), **caractérisée en ce que**
la première portion de circuit (220 ; 320 ; 510) reçoit un premier courant de queue (240 ; 340 ; 540) positivement proportionnel à un courant de signal d'entrée i (210 ; 310 ; 505) ; et
la seconde portion de circuit (230 ; 330 ; 530) reçoit un second courant de queue (250 ; 350 ; 545) négativement proportionnel au courant de signal d'entrée i (210 ; 310 ; 505),
les première (220 ; 320 ; 510) et seconde (230 ; 330 ; 530) portions de circuit étant opérationnelles pour produire un courant de sortie $I_{out}$ (260 ; 360 ; 560) de la cellule d'élévation au carré proportionnel à un produit des premier (240 ; 340 ; 540) et second (250 ; 350 ; 545) courants de queue ; dans laquelle le courant de sortie $I_{out}$ (260 ; 360 ; 560) est en corrélation avec le carré du courant de signal d'entrée i (210 ; 310 ; 505).

2. Cellule d'élévation au carré (200 ; 300 ; 500) selon la revendication 1, dans laquelle le courant de sortie $I_{out}$ (260 ; 360 ; 560) est sensible au premier courant de queue (240 ; 340 ; 540) et au second courant de queue (250 ; 350 ; 545).

3. Cellule d'élévation au carré (200 ; 300 ; 500) selon la revendication 2, dans laquelle le premier courant de queue (240 ; 340 ; 540) est une sommation d'un courant de repos CC $I_B$ et du courant de signal d'entrée i (210 ; 310 ; 505) ; et le second courant de queue (250 ; 350 ; 545) est une soustraction entre le courant de repos CC $I_B$ et le courant de signal d'entrée i (210 ; 310 ; 505).

4. Cellule d'élévation au carré (200 ; 300) selon la revendication 3, dans laquelle la première portion de circuit (220 ; 320) comprend un premier composant (410) avec une première borne positive et une première borne négative, où la première borne négative reçoit le premier courant de queue (240 ; 340) et la première borne positive se connecte à une tension de référence Vcc ; et la seconde portion de circuit (230 ; 330) comprend :

   un premier transistor (420) avec son électrode émettrice recevant le second courant de queue (250 ; 350), son électrode de base connectée à la borne négative du premier composant (410) et son électrode collectrice connectée à la tension de référence Vcc, des deuxième (430) et troisième (450) transistors ayant leurs électrodes émettrices raccordées ensemble recevant un premier courant constant, dans laquelle l'électrode de base du deuxième transistor (430) est connectée à l'électrode émettrice du premier transistor (420) et l'électrode collectrice du troisième transistor (450) est connectée au courant de sortie $I_{out}$ (260 ; 360), un deuxième composant (440) avec une borne positive et une borne négative, où la borne négative est connectée à l'électrode collectrice du deuxième transistor (430) et la borne positive est connectée à la tension de référence Vcc, et un quatrième transistor (460) ayant son électrode de base connectée à l'électrode collectrice du deuxième transistor (430), son électrode émettrice raccordée à l'électrode de base du troisième transistor (450) recevant un deuxième courant constant et son électrode collectrice connectée à la tension de référence Vcc.

5. Cellule d'élévation au carré (200 ; 300) selon la revendication 4, dans laquelle le premier composant (410) et/ou le deuxième composant (440) incluent un élément parmi :

   une diode avec sa borne d'anode servant de borne positive et sa borne de cathode servant de borne négative ; et un transistor avec son électrode de base et son électrode collectrice raccordées ensemble, où l'électrode émettrice sert de borne négative et l'électrode collectrice de borne positive.

6. Cellule d'élévation au carré (200 ; 300) selon la revendication 4, dans laquelle le premier courant constant est le double du courant de repos CC $I_B$.

7. Cellule d'élévation au carré (200 ; 300) selon la revendication 4, dans laquelle le deuxième courant constant est identique au courant de repos CC $I_B$.

8. Cellule d'élévation au carré (200 ; 500) selon la revendication 3, dans laquelle le courant de sortie $I_{out}$ (260 ; 560) de la cellule d'élévation au carré (200 ; 500) est une sommation d'un premier courant de sortie (515) de la première portion de circuit (220 ; 510) et d'un second courant de sortie (535) de la seconde portion de circuit (230 ; 530).

9. Cellule d'élévation au carré (200 ; 500) selon la revendication 8, dans laquelle le premier courant de sortie (515) est en corrélation avec le carré du courant de signal d'entrée i (210 ; 505).

10. Cellule d'élévation au carré (200 ; 500) selon la revendication 8, dans laquelle le second courant de sortie (535) est en corrélation avec le carré du courant de signal d'entrée i (210 ; 505).

11. Cellule d'élévation au carré (200 ; 500) selon la revendication 8, dans laquelle la première portion de circuit (220 ;

510) comprend :

un premier transistor (640) avec son électrode émettrice recevant le premier courant de queue (240 ; 540) et son électrode de base connectée à la seconde portion de circuit (230 ; 530) ;

un premier composant (645) avec une première borne positive et une première borne négative ayant la première borne négative connectée à l'électrode collectrice du premier transistor (640) et la première borne positive connectée à une tension de référence Vcc ;

des deuxième (635) et troisième (625) transistors ayant leurs électrodes émettrices raccordées ensemble recevant un premier courant constant, dans laquelle l'électrode de base du deuxième transistor (635) est connectée à l'électrode émettrice du premier transistor (640) ;

un deuxième composant (630) avec une deuxième borne positive et une deuxième borne négative ayant la deuxième borne négative connectée à l'électrode collectrice du deuxième transistor (635) et la deuxième borne positive connectée à la tension de référence Vcc ;

un quatrième transistor (620) ayant son électrode collectrice connectée au premier courant de sortie (515) et son électrode émettrice connectée à l'électrode collectrice du troisième transistor (625) ; et

des cinquième (610) et sixième (605) transistors connectés en série ayant l'électrode émettrice du sixième transistor (605) connectée à l'électrode collectrice du cinquième transistor (610), où l'électrode de base du cinquième transistor (610) est connectée à l'électrode collectrice du deuxième transistor (635), l'électrode émettrice du cinquième transistor (610) reçoit un deuxième courant constant et l'électrode de base du sixième transistor (605) est raccordée à la fois à l'électrode collectrice du sixième transistor (605) et à l'électrode de base du quatrième transistor (620), se connectant ensemble à la tension de référence Vcc.

12. Cellule d'élévation au carré (200 ; 500) selon la revendication 11, dans laquelle le premier composant (645) et/ou le deuxième composant (630) incluent un élément parmi :

une diode avec sa borne d'anode servant de borne positive et sa borne de cathode servant de borne négative ; et
un transistor avec son électrode de base et son électrode collectrice raccordées ensemble, où l'électrode émettrice sert de borne négative et l'électrode collectrice de borne positive.

13. Cellule d'élévation au carré (200 ; 500) selon la revendication 11, dans laquelle la seconde partie (220 ; 530) comprend :

un septième transistor (655) avec son électrode émettrice recevant le second courant de queue (250 ; 545), son électrode de base connectée à l'électrode collectrice du premier transistor (640) et son électrode collectrice connectée à l'électrode de base du premier transistor (640) de la première partie (220 ; 510) ;

un troisième composant (660) avec une troisième borne positive et une troisième borne négative ayant la troisième borne négative connectée à l'électrode collectrice du septième transistor (655) et la troisième borne positive connectée à la tension de référence Vcc ;

des huitième (670) et neuvième (675) transistors ayant leurs électrodes émettrices raccordées ensemble recevant un troisième courant constant, dans laquelle l'électrode de base du huitième transistor (670) est connectée à l'électrode émettrice du septième transistor (655) ;

un quatrième composant (665) avec une quatrième borne positive et une quatrième borne négative ayant la quatrième borne négative connectée à l'électrode collectrice du huitième transistor (670) et la quatrième borne positive connectée à la tension de référence Vcc ;

un dixième transistor (680) ayant son électrode collectrice connectée au second courant de sortie (535) et son électrode émettrice connectée à l'électrode collectrice du neuvième transistor (675) ; et

des onzième (695) et douzième (690) transistors connectés en série ayant l'électrode émettrice du douzième transistor (690) connectée à l'électrode collectrice du onzième transistor (695), où l'électrode de base du onzième transistor (695) est connectée à l'électrode collectrice du huitième transistor (670), l'électrode émettrice du onzième transistor (695) reçoit un quatrième courant constant et l'électrode de base du douzième transistor (690) est raccordée à la fois à l'électrode collectrice du douzième transistor (690) et à l'électrode de base du dixième transistor (680), se connectant ensemble à la tension de référence Vcc.

14. Cellule d'élévation au carré (200 ; 500) selon la revendication 13, dans laquelle le troisième composant (660) et/ou le quatrième composant (665) incluent un élément parmi :

une diode avec sa borne d'anode servant de borne positive et sa borne de cathode servant de borne négative ; et
un transistor avec son électrode de base et son électrode collectrice raccordées ensemble, où l'électrode émettrice sert de borne négative et l'électrode collectrice de borne positive.

**15.** Cellule d'élévation au carré (200 ; 500) selon la revendication 13, dans laquelle le premier ou le troisième courant constant est le double du courant de repos CC $I_B$.

FIG. 1
(PRIOR ART)

FIG. 2

FIG. 3

FIG. 4

FIG. 5

FIG. 6

FIG. 7A

FIG. 7B

FIG. 7C

FIG. 7D

FIG. 8A

FIG. 8B

FIG. 8C

FIG. 8D